# EUROPEAN PATENT SPECIFICATION

(11) **EP 3 460 499 B1**
(45) Date of publication and mention of the grant of the patent: **24.06.2020**
(21) Application number: 18181052.4
(22) Date of filing: 01.07.2018
(51) Int. Cl.: G01R 33/04, G01R 33/00

(54) **ORTHOGONAL FLUXGATE SENSOR**
ORTHOGONALER FLUXGATE-SENSOR
CAPTEUR FLUXGATE ORTHOGONAL

(30) Priority: 30.06.2017 CZ 20170386
(43) Date of publication of application: 27.03.2019
(73) Proprietor: Ceské vysoké ucení technické v Praze, 16000 Praha 6- Dejvice (CZ)
(72) Inventor: JANOSEK, Michal, 40755 Dolni Podluzi (CZ); BUTTA, Mattia, 16000 Praha 6 - Bubenec (CZ)
(74) Representative: Kratochvil, Vaclav

(56) References cited:
- WO-A1-2017/210328
- FR-A1- 2 979 787
- JP-A- 2008 275 578
- JP-A- 2017 015 656
- BUTTA MATTIA ET AL: "Very low frequency noise reduction in orthogonal fluxgate", AIP ADVANCES, AMERICAN INSTITUTE OF PHYSICS, 2 HUNTINGTON QUADRANGLE, MELVILLE, NY 11747, vol. 8, no. 4, 17 October 2017 (2017-10-17), XP012222917, DOI: 10.1063/1.4994208 [retrieved on 2017-10-17]

## Description

### Field of the Invention

The solution concerns the construction of a single-axis orthogonal fluxgate sensor designed to measure magnetic fields.

### Background of the Invention

The fluxgate sensor to measure magnetic field consists of a ferromagnetic core and several coils. The principle of the fluxgate sensor activity is based on the alternating excitation of the ferromagnetic core by the so-called excitation field, for example, from the excitation coil, and on the detection of the flux changes caused by external, i.e. measured magnetic field induced in the sensing coil. A detailed description of the fluxgate sensor activity and its various embodiments have been described, for example, in the book by P. Ripka, "Magnetic Sensors and Magnetometers", Artech House 2001. Structurally, the fluxgate sensor typically consists of a ferromagnetic core excited either directly or by a magnetic field from the wound excitation coil and the sensing coil wound around the ferromagnetic core. If the sensor operates in the feedback compensated mode, another compensating coil may be added, coaxial with the sensing coil, which forms a compensating magnetic field.

In the case of an orthogonal fluxgate sensor, one possibility is to use a cylindrical shape of a ferromagnetic core around which the ferromagnetic core is toroidally wound, as disclosed in the patent application EP1746430A1. Alternatively, instead of the excitation coil, a current flowing directly through the ferromagnetic material can be used to excitation, see, for example, the US patent US2856581 A. The orthogonal fluxgate sensor without the excitation coil can preferably be operated with unipolar excitation, see Sasada, Orthogonal Fluxgate Mechanism Operated with DC Biased Excitation, Journal of Applied Physics 91, 10 (2002). Unipolar excitation is preferred for achieving very low magnetic noise of the sensor (∼1pT/√Hz@1Hz).

The ferromagnetic core of the fluxgate sensor is usually placed in a holder. One of the possible embodiments is described in the utility model CZ27638 - Fluxgate sensor. In the case of an orthogonal sensor with a rod (wire) core, the ferromagnetic core is typically placed into a protective cylindrical tube or attached to a flat holder. In the case of an orthogonal sensor without excitation coil, as in the above-mentioned case of rod or wire cores, the core is also conductively connected with external excitation circuits either directly to the electrical conductors or using conductive contacts on the holder to which the ferromagnetic core and external leads are conductively connected. In some current embodiments, the ferromagnetic core of the orthogonal sensor is further protected from oxidation by a non-conductive thin layer e.g. of polymer or glass, as mentioned, e.g. in the article by Mattia Butta, Orthogonal Fluxgates, published in Intech Open Access Publisher, www.intech.com, in 2012. In the case of a parallel fluxgate sensor, in some of the known solutions the core is completely embedded in epoxide, or in the case of etched cores, a thin, several µm thick photoresist layer is left to protect the etched core from oxidation, as shown, e.g. in the article by Pavel Ripka, Fluxgate Sensor with Increased Homogeneity, published in 1990 in IEEE Transactions on Magnetics, Number 5, Volume 26, p. 2038-2040.

The disadvantage of current embodiments of orthogonal sensors with ferromagnetic cores is the method of placing the core in the holder - the core is in the known solutions placed in the holder tightly, or overhangs the holder or is fixed in points, and thus either the mechanical stresses are exerted on it due to various expansions (when placed tightly or coated by epoxide) or vibrations affect it (when overhangs or is fixed in points). All of the above methods cause an increase in low-frequency noise. Another problem is that in the case of orthogonal fluxgate sensor a significant excitation current passes through the core or excitation coil which causes the inhomogeneous core temperature due to inhomogeneity of the thermal properties of the material and the surroundings. If the sensor operates with unipolar excitation flowing directly through the sensor's core, another significant disadvantage is the Peltier's effect causing a temperature gradient along the core through which the electric current with the DC component flows. These two thermal effects caused by both the non-homogeneities and the effect of the Peltier's phenomenon, contribute to the increase of ultra-low frequency noise of the low frequency sensor (< 1 Hz). If the sensor additionally operates with multiple windings and serves to measure the magnetic field gradient, then both of these thermal effects are highly undesirable due to their uncorrelatability along the core, i.e. they cannot be suppressed by the gradiometric arrangement. Thermal inhomogeneity could be solved similarly to parallel sensors by embedding the core into a thermally conductive epoxide, but high mechanical stresses, like thermal effects, cause ultralow-frequency noise to increase in the low frequency range below 1 Hz. Embedding into epoxide will not bring any improvement and therefore it is not used in the background of the invention for low noise sensors.

If the sensor uses an excitation current flowing directly through the ferromagnetic core, in the current state of the art, the electrically conductive connection between the core and contacts is carried out either by mechanical connection or using a layer of electrically conductive adhesive or cement, or the ferromagnetic core is directly soldered to the contact. The disadvantage of the above solutions is either the instability of electrical properties of a mechanical contact, or a large transition resistance when using adhesives or cements, or unfavourable chemical and electrical properties in the direct connection of the solder and the ferromagnetic material of the core (the ferromagnetic core contains iron and other metals, such as cobalt or chrome, which make it difficult or even impossible to solder). In the known solution of the application EP1746430A1 this problem is solved in part by applying electrolytically the ferromagnetic material to the copper wire or strip, while the conductive connection by soldering is carried out at the ends of the wire and the layer of ferromagnetic material is applied electrolytically in the area between these ends of the wire, but not at its ends. The disadvantage of this solution is that it is limited to the ferromagnetic core embodiment as an electrolytically applied layer on a copper substrate. In the background of the invention, however, the best results are achieved by the ferromagnetic cores drawn in full profile from the amorphous material, i.e. without the copper substrate, see for example Sasada, Orthogonal Fluxgate Mechanism Operated with DC Biased Excitation, Journal of Applied Physics 91, 10 (2002). However, for them there has not yet been a solution for how to position and fix the core into the coil that would not be associated with the occurrence of unwanted mechanical stresses or vibrations. Document FR 2979787 discloses the preamble of claim 1.JP 2017015656, JP 2008275578 and WO 2017210328 disclose a fluxgate sensor with material surrounding the ferromagnetic core.

### Summary of the Invention

The above-mentioned disadvantages are eliminated by the new embodiment of the orthogonal fluxgate sensor consisting of one or more ferromagnetic cores and one or more sensing coils, optionally also one or more compensating coils, wherein the ferromagnetic core of the sensor of any shape and design that can be attached to the first holder is placed in the sensing coil. The ferromagnetic core is at least on 50 % of its surface and 50 % of its length embedded with filler material with good thermal conductivity and low hardness, resulting in a significant reduction of thermal inhomogeneities of the core and an increase in its thermal inertia. Unwanted mechanical stresses do not act on the core and at the same time the core attachment is vibration resistant.

The orthogonal fluxgate sensor of the invention is defined by claim 1.

Preferred embodiments are defined by the dependent claims.

The advantage of the present solution is that the ferromagnetic core is in good thermal and mechanical contact with the filler material, which is at the same time enclosed in the volume of a dimensionally stable holder, which contributes to the reduction of a low frequency noise through suppression of temperature inhomogeneities and gradients and also due to the decrease of mechanical effects on the magnetic properties of the core, e.g. due to vibrations, etc.

### Description of Drawings

Various embodiments of the orthogonal fluxgate sensor of the present invention are shown in the accompanying drawings.
Fig. 1 shows a preferred placement of a rod-shaped ferromagnetic core on the first holder.
Fig. 2 shows the completed assembly of the fluxgate sensor with core of Figure 1 and illustrates the location of the first holder in the second holder having a hollow cylinder shape and the location of the sensing coil which is wound around the second holder and hence also around the ferromagnetic core; the entire remaining space in the second holder is filled with filler material.
Fig. 3 presents a cross-section obtained by cutting along the plane A1 marked in Figs. 1 and 2 and shows a preferred embodiment of the ferromagnetic core attachment to the first holder by means of soft soldering on electrically applied contacts on the ferromagnetic core.
Fig. 4 shows an embodiment of the ferromagnetic core in the shape of a hollow cylinder with the excitation coil.
Fig. 5 shows the completed assembly of the sensor with the sensing coil on the second holder when the entire remaining space within the second holder is filled with filler material and the ferromagnetic core is in the embodiment of Fig. 4.
Fig. 6 shows a similar embodiment as in Fig. 2 in a longitudinal section taken at the place of the largest transverse dimension of the ferromagnetic core. The difference with the configuration of Fig. 2 is that there are two sensing coils on a common holder. The core in Fig. 6 is in contact with the filler material for more than 50 % of its length and surface.
Fig. 7 shows another possible embodiment in a longitudinal section taken at the place of the largest transverse dimension of the ferromagnetic core when two cores are located in the second holder on which two sensing coils are placed and the filler material fills the space of the coil holder so that the core is in contact with this mass for more than 50 % of its length and surface.
Fig. 8 shows a similar embodiment to Fig. 7, again in a longitudinal section taken at the place of the largest transverse dimension of the ferromagnetic core, with other coils being directly wound on sensing coils, which preferably serve for feedback compensation.
Fig. 9 shows a sensor with one ferromagnetic core in a longitudinal section taken at the place of the largest transverse dimension of the ferromagnetic core in an embodiment in which a compensating coil on an external holder is wound around the sensing coil. The space of the self-supporting sensing coil is filled with filler material so that more than 50 % of the length and surface of the ferromagnetic core is in contact with this mass.

### Examples of the Invention Embodiments

The exemplary configurations described below show only some of the possible solutions that fall within the scope of the invention protection and illustrate the inventive idea. These are only selected preferred embodiments which in no way limit the scope of the invention protection. Various examples of the core embodiments can be combined, for example, with different ways of attaching it to various holders described below. It is also possible to combine different shapes of holders for different cores, with different geometries of sensing and other coils, and the like. When the filler material with the properties of claim 1 is used, all such combinations fall within the scope of the present invention protection.

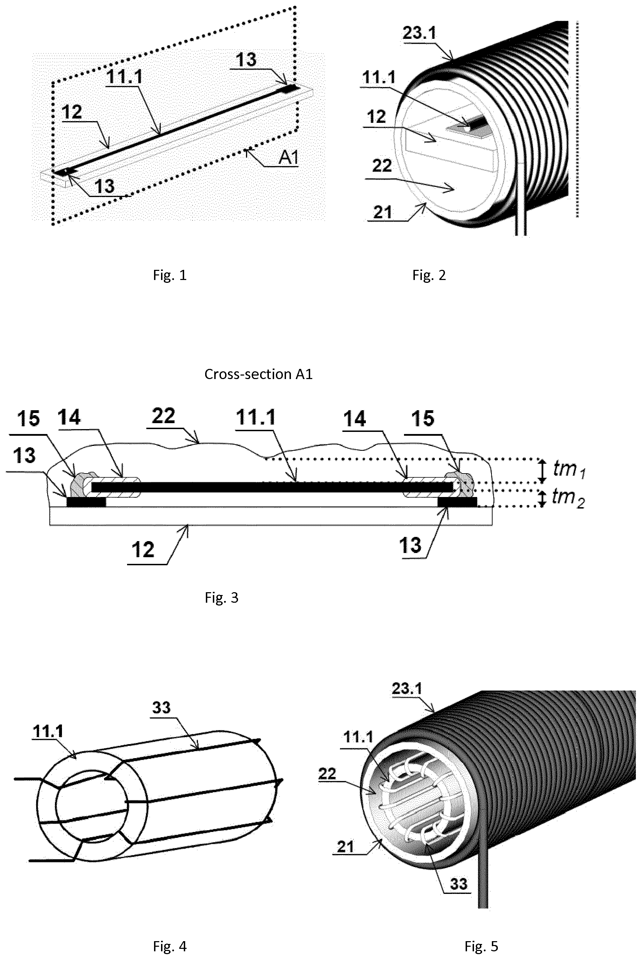

One possible embodiment of the fluxgate sensor is schematically shown in Figs. 1 and 2. Fig. 1 shows the first holder 12 to which on two copper contacts 13 a ferromagnetic core 11 is soldered, in this case a rod core which has the form of a ferromagnetic wire. In one possible embodiment, the assembly of the ferromagnetic core 11 and the first holder 12 is placed in the second holder 21 of Fig. 2. The second holder 21 is in this case made as a tube having a 1 mm clearance in one preferred embodiment. Almost the entire remaining space between the ferromagnetic core 11, the first holder 12 and the second holder 21 is filled with a filler material 22. This material has a high thermal conductivity and low hardness. It is also preferable if it has a small thermal expansion. These properties are necessary for the proper functioning of the sensor of the present invention. For example, the thermally conductive silicone has these properties. A sensing coil 23 is wound around the second holder 21. It is preferable if the sensing coil 23 is also used for feedback compensation. These coils may be in higher number in other embodiments. The sensing coil 23 or sensing coils 23.1, 23.2 can also be self-supporting in other embodiments, i.e. without the second holder 21. The number of sensing coils or ferromagnetic cores is not limited. For example, the first holder 12 can be milled from a fiberglass printed circuit board of a width and thickness allowing for tight insertion into the second holder 21 tube. It is preferable if the inner space of the second holder 21 is filled with the filler material 22, for example the thermally conductive silicone, prior to the insertion of the first holder 12 with the ferromagnetic core 11, thus ensuring almost complete filling of the space with this material.

The preferred possibility of attaching ferromagnetic core 11 to the first holder 12 is illustrated in Fig. 3 in a cross-section along the plane A1 which is parallel to the longitudinal axis of the ferromagnetic core and whose position is shown in Figs. 1 and 2. Compared to Fig. 1, the filler material 22, which is irregular in shape, is also drawn. For simplicity, Fig. 3 does not show the hollow object, which in the embodiments of the present invention spatially defines this filler material 22. The ferromagnetic core 11 is electrolytically plated at its both ends 14 and is attached to the first holder 12 by soft soldering 15 of electrolytically plated ends 14 of the core to the contacts 13 on the first holder 12, wherein the shape of the first holder 12 is adapted to be inserted into the second holder 21. In addition to the mechanical attachment, the soldering also provides the electrical contact required to connect the external excitation circuits of the core. A further advantage is that the filler material 22 surrounds the whole ferromagnetic core 11, except for the contacts.

Another example of embodiment of the orthogonal fluxgate sensor is shown in Figs. 4 and 5. An excitation coil 33 is toroidally wound around the ferromagnetic core 11 having a shape of hollow cylinder - see Fig. 4. The hollow cylindrical ferromagnetic core 11 is placed in the second holder 21, with clearance of 1 mm in preferred embodiment, around which the sensing coil 23 is wound. The space between the ferromagnetic core 11 together with the excitation coil 33 and the second holder 21 is almost completely filled with the said filler material 22, wherein the filler material 22 additionally fills the hollow portion of the cylindrical ferromagnetic core 11. In this embodiment, the ferromagnetic core 11 is not attached to the first holder, i.e. the core inside the second holder 21 is overhung. Again, it is preferable if the inner space of the second holder 21 is filled with the filler material 22 prior to insertion of the ferromagnetic core 11 with the excitation coil 33, which ensures an almost complete filling of the space with this filler material 22.

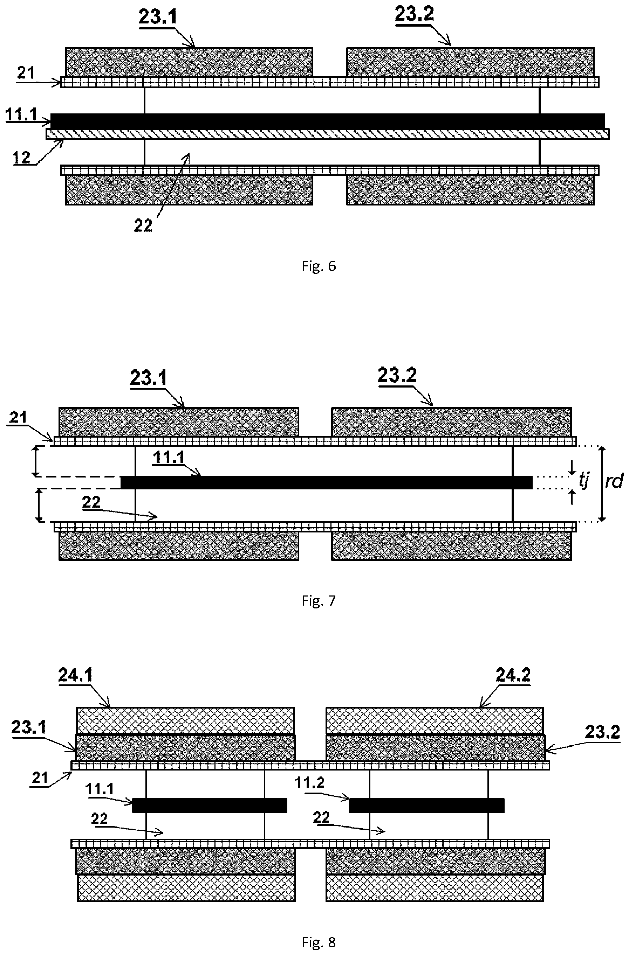

In Fig. 6, a further possible embodiment with two sensing coils 23.1 and 23.2 and the first holder 12 is shown in the longitudinal section taken at the place of the largest transverse dimension of the ferromagnetic core 11, when again the assembly of the ferromagnetic core 11 and the first holder 12 is placed in the second holder 21 and the second holder 21 is in this case made as a tube. The space between the ferromagnetic core and the second holder 21 is filled with the filler material 22 so that it covers more than 50 % of the length and more than 50 % of the core surface. Two sensing coils 23.1, 23.2 are wound around the second holder 21, which can be used, for example, to measure the magnetic field gradient. It is preferable if these sensing coils 23.1, 23.2 are also used for feedback compensation.

Fig. 7 shows in a longitudinal section taken at the place with the largest transverse dimension of the sensor a further possible embodiment with two ferromagnetic cores 11.1, 11.2 having a shape of cylinder with a transverse dimension of 100 µm and two sensing coils 23.1, 23.2. This time, the cores are placed in the second holder 21 directly, i.e. without the first holder 12. The second holder 21 is a hollow cuboid with a cavity having a regular square cross-section; the transverse dimensions of the cavity are 1 x 1 mm. The space between each ferromagnetic core 11.1, 11.2 and the second holder 21 is filled with the filler material 22 around the ferromagnetic cores so that more than 50 % of the length and more than 50 % of the surface of the core are covered. Two sensing coils 23.1, 23.2 are wound around the second holder 21, which can be used, for example, to measure the magnetic field gradient. It is preferable if these sensing coils 23.1, 23.2 are also used for feedback compensation.

Fig. 8 shows in a longitudinal section taken at the place of the largest transversal dimension of the sensor an embodiment with two ferromagnetic cores 11.1, 11.2, two sensing coils 23.1, 23.2 and two additional coils 24.1, 24.2, which are preferably used for feedback compensation. The cores are placed in the second holder 21 directly, i.e. without the first holder 12. The second holder 21 is made as a tube. The space between each ferromagnetic core and the second holder 21 is filled with the filler material 22 so that more than 50 % of the length and more than 50 % of the surface of each ferromagnetic core is covered. Two sensing coils 23.1, 23.2 are wound around the second holder 21, which can be used, for example, to measure the magnetic field gradient. Two additional coils 24.1 and 24.2 are wound around these coils. It is preferable if these additional coils 24.1 and 24.2 are used for feedback compensation.

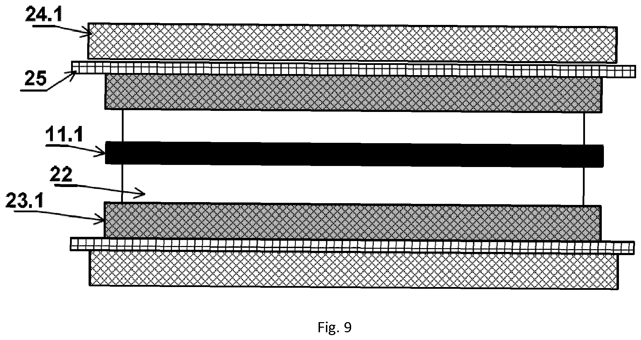

Fig. 9 shows in a longitudinal section taken at the place of the largest transversal dimension of the sensor an embodiment with a single cylinder shaped ferromagnetic core with a transverse dimension, i.e. thickness of 100 µm and sufficiently densely wound self-supporting sensing coil 23 with internal diameter of 1 mm. Again, the core is placed without the holder directly in the self-supporting sensing coil 23; the space between the core and the sensing coil 23 is filled with the filler material 22 so that it covers more than 50 % of both the length and surface of the core. External holder 25 is placed around the sensing coil and an additional coil 24 is wound on it, which preferably serves as a compensating coil.

Additional coils may be in higher number, typically the same number as the number of sensing coils. If no external holder 25 is used, each of the additional coils may be wound on one of the sensing coils, i.e. in the configuration with one sensing coil 23, one additional coil 24 is wound on it, in the configuration with two sensing coils 23.1 and 23.2, one additional coil 24.1 is wound on the sensing coil 23.1 and one additional coil 24.2 is wound on the sensing coil 23.2, as shown in Fig. 8.

In preferred embodiments, the ferromagnetic core has, for example, the shape of a rod, strip or hollow cylinder. The transverse dimension of the core or the largest transverse dimension of the core in the case of a non-homogeneous shape of the core is typically 100 µm, but the core may be of other dimensions if these dimensions allow it to be inserted into the second holder 21 and/or into the sensing coils 23, 23.1, and 23.2 when sufficient thickness of the filler material is ensured. The core is always placed in the sensing coil so that the change in magnetic flux in the core causes the induced voltage in the sensing coil characterised as having multiple individual threads encompassing the area S, which they close, and a normal defining orientation of this area S. For a coil with regular dimension, such as a solenoid, the normal to the area S is the same as the axis of the coil. The core dimension, which is at least approximately parallel to the normal of this area, is then the longitudinal dimension of the core. In the vast majority of cases, the longitudinal dimension of the core is longitudinal also geometrically, for example, this may be the length of the rod or strip or the height of the hollow cylinder. However, there may be situations where the core, for example, has the shape of a full circle having a diameter of 1 mm with a height (or thickness) of material of 100 µm (such core may be made by electrolytic application on a conductive circular disc). In this case, the longitudinal dimension of the core is that dimension that is parallel to the normal defining the orientation of the area S of the sensing coil.

The transverse dimensions of the core are then dimensions perpendicular to the longitudinal dimension of the core and typically define the cross-section or thickness of the core, but this need not be constant throughout the core.

As shown in Figs. 2, 5 and 6 to 9, the filler material 22 is always in the direct contact with the ferromagnetic core 11, 11.1, 11.2. This contact must be secured on at least 50 % of the surface of the ferromagnetic core 11, 11.1, 11.2. The ferromagnetic core 11, 11.1, 11.2 is at least partially located within the space filled with filler material 22. In a preferred embodiment, the filler material 22 is filled into a hollow object that defines it spatially in a fluid or pasty state, with the material solidifying in time. The filler material 22 must meet the following parameters: the final thermal conductivity, which we understand thermal conductivity after solidification, is better than 0.1 W·m⁻¹·K⁻¹ at 25 °C, and the final hardness at 25 °C, which we understand hardness after solidification, is between 5 and 70 in Shore A units. It is also preferable if the final linear coefficient of thermal expansion of the filler material at 25 °C, again meaning its value after solidification, is less than 1,000 ppm·K⁻¹. Low hardness of the filler material 22 is important to avoid the occurrence of unfavourable mechanical stresses due to the different temperature expansions of the material of the ferromagnetic core 11, 11.1, 11.2, holders 12, 21 and the said filler material 22. If the layer of this filler material 22 is sufficiently massive, from empirical experience with a thickness of at least 500 µm, it is possible to homogenize the temperature of the ferromagnetic core 11, 11.1, 11.2, which is metal, and therefore a good conductor of heat, and at the same time, accumulate this heat in the material, i.e. increase the inertia and thus move the range of reactions to temperature changes towards lower frequencies. From the example in Fig. 3, it will be appreciated that the said minimum dimension of 500 µm, that is the total thickness of the filler material 22, is given by the sum of the dimensions *tm*₁ and *tm*₂ which may not be the same.

At the same time, however, in order to achieve the shape stability and vibration resistance of the filler material 22 with such a low hardness after solidification, it is necessary to bound this material, to close it in space - the embodiment of Fig. 3 is not sufficient in itself. The space in which the filler material 22 is placed is therefore bounded at a length section equal to at least 50 % of the longitudinal dimension of the ferromagnetic core 11, 11.1, 11.2 in directions perpendicular to the longitudinal dimension of the core by at least one hollow object, which is illustrated in Figs 2 and 5 in an isometric view and in Figs. 6 to 9 in a cross-section. This hollow object has a longitudinal dimension of the hollow object and internal dimensions of the cavity measured perpendicularly to the longitudinal dimension of the hollow object. The longitudinal dimension of the hollow object means the largest dimension of the hollow object, measured in a direction parallel or approximately parallel to the longitudinal dimension of the ferromagnetic core 11, 11.1, 11.2. The smallest internal dimension of the cavity of this hollow object on this length section is at least 500 µm greater than the largest transverse dimension of the ferromagnetic core 11, 11.1, 11.2. Methods for bounding the filler material 22 with a self-supporting sensing coil 23, 23.1, 23.2 or the second holder 21 are described above. It is preferable, if the ferromagnetic core 11, 11.1, 11.2 is attached to the first holder 12, for example by soldering, and the resulting assembly is inserted into the second holder 21, for example in the shape of a tube, and the inner space of the second holder 21 is embedded with the said filler material 22 so that at least 50 %, but preferably the entire surface of the ferromagnetic core is in contact with the material. However, it is most preferable when the core is surrounded to a maximum extent by the filler material 22 and the filler material 22 fills the maximum volume.

These parameters and methods of the filler material application already provide an acceptable reduction in undesirable thermal effects as well as mechanical stresses. In this configuration, therefore, the most significant reduction of ultra-low frequency noise in the low frequency region under 1 Hz is achieved.

Experimental demonstration of a specific embodiment of a directly excited orthogonal fluxgate sensor with a cylindrical core of amorphous material of length 40 mm and thickness 100 µm showed that the noise at frequencies between 0.01 and 0.1 Hz decreased to one third compared to the background of the invention. In this case, silicone having a final hardness after solidification Shore A 39 and thermal conductivity of approximately 0.2 WK⁻¹m⁻¹was used, which was bounded by a ceramic tube with 5 mm clearance serving as a holder for the sensing coil. The sensing coil was wound on the ceramic tube along the entire length of the ferromagnetic core and the entire inner space of the ceramic tube was filled with the said filler material.

The ferromagnetic core 11, 11.1, 11.2 is placed in the corresponding sensing coil 23, 23.1, 23.2 partially or in the most preferred embodiment in its entirety. In one preferred embodiment, the ferromagnetic core 11, 11.1, 11.2 is placed in the sensing coil 23, 23.1, 23.2 so that the longitudinal dimension of the ferromagnetic core 11, 11.1, 11.2 lies along the longitudinal axis of the sensing coil 23, 23.1, 23.2, or is at least approximately parallel to it. However, it is essential that the relative position of the ferromagnetic core 11, 11.1, 11.2 and the corresponding sensing coil 23, 23.1, 23.2 is such that the change in magnetic flux in the ferromagnetic core 11, 11.1, 11.2 causes the induced voltage in the respective sensing coil 23, 23.1, 23.2. This means that the angle which the axis of each sensing coil 23, 23.1, 23.2 forms with the longitudinal dimension of the ferromagnetic core 11, 11.1, 11.2 corresponding to the given sensing coil, must lie in the interval 0 ° to 90 °, which is closed from the bottom and open at the top.

The hollow object that spatially bounds the filler material 22 is in one exemplary embodiment, in the case of a sufficient viscosity of the filler material 22 and the sufficient winding density of the sensing coil 23, 23.1, 23.2, the sensing coil itself as shown in Fig. 9, where the sensing coil 23 is self-supporting. In other preferred embodiments, the hollow object that spatially bounds the filler material 22 is the second holder 21. The sensing coils 23, 23.1, 23.2 are then attached to this second holder either by being wound on the second holder 21 or by other methods. However, the device may also operate so that some of the ferromagnetic cores 11, 11.1, 11.2 are inserted into one of the sensing coils 23, 23.1, 23.2 separately, i.e. without the first holder 12. Thus, there may be embodiments in which only the first holder 12, the second holder 21, the two holders 12 and 21 at the same time or no holder at all are present, provided that the core overhangs the sensing coil 23, 23.1, 23.2. When two holders are present, the embodiment of the first holder 12 is preferably adapted so that the longitudinal dimension of the ferromagnetic core 11, 11.1, 11.2 is at least approximately parallel to the longitudinal dimension or axis of the second holder 21, wherein the axis of the holder 21 in the most preferred embodiment coincides with the axis of the sensing coil 23, 23.1, 23.2.

The smallest internal diameter of the corresponding sensing coil 23, 23.1, 23.2 and/or the internal dimension of the second holder 21 cavity (i.e. the clearance in the case of a hollow cylinder) must logically be the sum of the largest transverse dimension (i.e. thickness) of the ferromagnetic core 11 and the minimum total thickness of the filler material which was empirically determined as 500 µm. For example, if the ferromagnetic core 11 is in the shape of a cylinder, its thickness (transverse dimension), i.e. the cylinder diameter, is typically between 50 and 150 µm. Then, in this particular case, the smallest internal diameter of the sensing coil 23, 23.1, 23.2 and/or the smallest internal dimension of the cavity of the second holder 21 (i.e. clearance in the case of a hollow cylinder) is equal to the sum of the total thickness of the filler material and the core thickness, i.e. the smallest internal dimension of the cavity is typically between 550 and 650 µm. A specific example is shown in Fig. 7 - the core thickness is marked *tj* and the internal dimension of the cavity or clearance of the second holder 21 (for example, the internal diameter of the cylinder in the case of a cylindrical holder) is marked *rd.* The internal dimension of the cavity *rd* is then given by the sum of the thickness of the core *tj* and the total thickness of the material *tm*=*tm*₁+*tm*_{2.} If the ferromagnetic core 11 or ferromagnetic cores 11.1, 11.2 are coaxial with the holder 21, as shown in Fig.7, the equation *tm*₁ = *tm*₂ applies as well.

The material of the first holder 12 and the second holder 21 is any non-ferromagnetic material, preferably with high thermal conductivity and low expansion, for example ceramics or special technical plastics. The second holder 21 may, for example, have the form of a ceramic tube.

For conductive connection of the ferromagnetic core with external circuits, it is also preferable if the ends of the ferromagnetic core are electrolytically plated with a copper layer and these ends are soldered to the contacts on the holder or directly to the electric conductors, thereby achieving a defined thermally and chemically stable electrical contact. It is then preferable if this electrically conductive connection of the ferromagnetic core with the contacts is at the same time the only mechanical connection with the holder. Then after embedding, the filler material, except for these two electrical contacts, is in contact with almost the entire surface of the ferromagnetic core.

In a preferred embodiment, the sensing coil or sensing coils 23, 23.1, 23.2 are also used for feedback compensation by being as in known solutions connected to both the detection circuits of an electronic device where the sensed signal is processed and the output of the compensating feedback where the compensating current to compensate for measured magnetic field is generated. In another possible embodiment, the said feedback compensating coil is formed as an additional coil or coils 24, 24.1, 24.2, wound directly to the corresponding sensing coils 23, 23.1, 23.2, or to an optional external holder 25 so that the additional coils 24, 24.1, 24.2 are coaxial with their respective sensing coils 23, 23.1, 23.2.

In another possible embodiment, a plurality of sensing coils, e.g. two coils 23.1, 23.2, is wound around the ferromagnetic core 11, which are arranged one after the other in the direction of the longitudinal dimension of the ferromagnetic core as shown in Fig. 6, wherein additional coils 24.1, 24.2 may be placed around these sensing coils or around the external holder 25, which surrounds these sensing coils, as described in the previous paragraph. There may be larger number of sensing coils and additional coils than two of each type. In a similar assembly, multiple ferromagnetic cores, e.g. ferromagnetic cores 11.1, 11.2 may be inside multiple sensing coils, e.g. sensing coils 23.1, 23.2. Some of these configurations are shown in Figs. 7 and 8. These multiple-sensing coil configurations then allow for the measurement of the magnetic field gradient of the first or higher orders according to the number of coils.

### Industrial Applicability

The orthogonal fluxgate sensor finds use in geophysics, security and military applications, and wherever it is necessary to measure components of the magnetic field vector with a very low noise in ultra-low frequencies (under 1 Hz).

### List of reference numbers

11, 11.1, 11.2 - Ferromagnetic core
12 - First holder
13 - Contacts
14 - Ends of the ferromagnetic core
15 - Solder
21 - Second holder
22 - Filler material
23, 23.1, 23.2 - Sensing coil
24, 24.1, 24.2 - Additional coil
25 - External holder
33 - Excitation coil

## Claims

1. An orthogonal fluxgate sensor comprising at least one ferromagnetic core (11, 11.1, 11.2) having a longitudinal dimension of the core and transverse dimensions of the core measured perpendicular to the longitudinal dimension of the core and sensing coil (23, 23.1, 23.2), wherein the ferromagnetic core (11, 11.1, 11.2) is at least partially placed inside the sensing coil (23, 23.1, 23.2) so that the change in magnetic flux in the ferromagnetic core causes an induced voltage in the sensing coil (23, 23.1, 23.2), **wherein** the orthogonal fluxgate sensor comprises further a filler material (22), the ferromagnetic core (11, 11.1, 11.2) being at least partially embedded in the filler material (22) so that at least 50 % of the surface of the ferromagnetic core is in direct contact with the filler material (22)
whose coefficient of thermal conductivity at 25 °C after solidification is greater than 0.1 Wm⁻¹K⁻¹ and whose Shore A hardness at 25°C after solidification is from 5 to 70, wherein the filler material (22) has a length section equal to at least 50 % of the longitudinal core dimension, and external dimensions measured perpendicularly to the longitudinal dimension
of the core, **characterised in that** the smallest external dimension of said external dimensions of the filler material (22) is at least by 500 µm greater than the largest transverse dimension of the ferromagnetic core (11, 11.1, 11.2).

2. The orthogonal fluxgate sensor according to claim 1, **wherein** the sensing coil (23, 23.1, 23.2) directly bounds the filler material (22) or the orthogonal fluxgate sensor comprises further a second holder (21), which is hollow and to which the sensing coil (23, 23.1, 23.2) is attached so that the ferromagnetic core (11, 11.1, 11.2) is at least partially inside the second holder (21) cavity.

3. The orthogonal fluxgate sensor according to claim 1 or 2,
**comprising further** an external holder (25) located outside the sensing coil (23, 23.1, 23.2) and one or more additional coils (24, 24.1, 24.2) that are attached either to the external holder (25) or directly to the sensing coil (23, 23.1, 23.2).

4. The orthogonal fluxgate sensor according to any one of claims 1
to 3, **wherein** the ferromagnetic core (11, 11.1, and 11.2) has the shape of a rod or stripe.

5. The orthogonal fluxgate sensor according to any one of claims 1
to 3, **wherein** the ferromagnetic core (11, 11.1, and 11.2) has the shape of a hollow cylinder.

6. The orthogonal fluxgate sensor according to any one of claims 1 to 5, **comprising further** first holder (12), wherein the ferromagnetic core (11, 11.1, 11.2) is attached to the first holder (12).

7. The orthogonal fluxgate sensor according to claim 6, **wherein** the ferromagnetic core (11, 11.1, 11.2) is electrolytically plated at its ends (14) and attached to the first holder (12) by connecting these ends with a soft solder (15) to the contacts (13) formed at the first holder (12),
and the first holder (12) is inserted in the sensing coil (23, 23.1, 23.2) either directly or, when the orthogonal fluxgate sensor comprises a further second holder (21), it is inserted in the second holder (21) that is placed in one or more sensing coils (23, 23.1, 23.2).

## Patentansprüche

1. Orthogonaler Fluxgate-Magnetfeldsensor umfassend mindestens einen ferromagnetischen Kern (11, 11.1, 11.2) mit einer Längsabmessung des Kerns und Querabmessungen des Kerns, gemessen senkrecht zu der Längsabmessung des Kerns, und eine Sensorspule (23, 23.1, 23.2), wobei der ferromagnetische Kern (11, 11.1, 11.2) sich zumindest teilweise in der Sensorspule (23, 23.1, 23.2) befindet, so dass die Änderung des Magnetflusses im ferromagnetischen Kern eine induzierte Spannung in der Sensorspule (23, 23.1, 23.2) auslöst, wobei die orthogonaler Fluxgate-Magnetfeldsensor weiterhin ein Füllmaterial (22) umfasst, der ferromagnetische Kern (11, 11.1, 11.2) befindet sich zumindest teilweise in dem mit dem Füllmaterial (22) gefüllten Bereich, so dass mindestens 50% der Oberfläche des ferromagnetischen Kerns in direktem Kontakt mit diesem Füllmaterial (22) steht, dessen Wärmeleitfähigkeitskoeffizient bei 25°C nach Aushärtung größer als 0,1 Wm⁻¹K⁻¹ ist und dessen Härte nach Shore-Skala und bei 25°C nach Aushärtung zwischen 5 und 70 liegt, wobei dieses Füllmaterial (22) in einem Längsabschnitt gleich mit mindestens 50% der Längsabmessung des Kerns und Außenabmessungen ist, gemessen senkrecht zu der Längsabmessung des Kerns, **gekennzeichnet dadurch, dass** die kleinste Außenabmessung dieses Füllmaterials (22) mindestens um 500 µm größer als die größte Querabmessung des ferromagnetischen Kerns (11, 11.1, 11.2) ist.

2. Orthogonaler Fluxgate-Magnetfeldsensor nach Anspruch 1, **wobei** es ist direkt die Sensorspule (23, 23.1, 23.2), die räumlich das Füllmaterial (22) begrenzt, oder die orthogonaler Fluxgate-Magnetfeldsensor umfasst weiterhin einen zweiten Halter (21), der hohl ist und auf dem die Sensorspule (23, 23.1, 23.2) befestigt ist, so dass sich der ferromagnetische Kern (11, 11.1, 11.2) zumindest teilweise im Hohlraum des zweiten Halters (21) befindet.

3. Orthogonaler Fluxgate-Magnetfeldsensor nach Anspruch 1 oder 2, **ferner umfassend** einen externen Halter (25), der sich außerhalb der Sensorspule (23, 23.1, 23.2) befindet, und eine oder mehrere weitere Spulen (24, 24.1, 24.2), die entweder am externen Halter (25) oder direkt an der Sensorspule (23, 23.1, 23.2) befestigt sind.

4. Orthogonaler Fluxgate-Magnetfeldsensor nach einem der Ansprüche 1 bis 3, **wobei** der ferromagnetische Kern (11, 11.1, 11.2) die Form eines Stabes oder eines Bandes hat.

5. Orthogonaler Fluxgate-Magnetfeldsensor nach einem der Ansprüche 1 bis 3, **wobei** der ferromagnetische Kern (11, 11.1, 11.2) die Form eines Hohlzylinders hat.

6. Orthogonaler Fluxgate-Magnetfeldsensor nach einem der Ansprüche 1 bis 5, **umfassend** weiterhin ersten Halter (12), wobei der ferromagnetische Kern (11, 11.1, 11.2) an diesem ersten Halter (12) befestigt ist.

7. Orthogonaler Fluxgate-Magnetfeldsensor nach Anspruch 6, **wobei** der ferromagnetische Kern (11, 11.1, 11.2) an seinen Enden (14) elektrolytisch plattiert und am ersten Halter (12) befestigt ist, und dies durch Löten mit weichem Lot (15) dieser Enden (14) an die Kontakte (13) auf diesem ersten Halter (12), und dieser erste Halter (12) ist in die Sensorspule (23, 23.1, 23.2) eingesetzt, entweder direkt, oder wenn die orthogonaler Fluxgate-Magnetfeldsensor weiterhin einen zweiten Halter (21) umfasst, ist er in den zweiten Halter (21) eingesetzt, der in einer oder mehreren Sensorspulen (23, 23.1, 23.2) angeordnet ist.

## Revendications

1. Sonde magnétométrique orthogonale comprenant au moins un noyau ferromagnétique (11, 11.1, 11.2) ayant une dimension longitudinale du noyau et les dimensions transversales du noyau mesurées perpendiculairement à la dimension longitudinale du noyau et une bobine de détection (23, 23.1, 23.2), le noyau ferromagnétique (11, 11.1, 11.2) étant situé au moins partiellement à l'intérieur de la bobine de détection (23, 23.1, 23.2) de sorte qu'un changement de flux magnétique dans le noyau ferromagnétique provoque une tension induite dans la bobine de détection (23, 23.1, 23.2), la sonde magnétométrique orthogonale comprenant également un matériau de remplissage (22), le noyau ferromagnétique (11, 11.1, 11.2) est au moins partiellement situé à l'intérieur de la zone remplie du matériau de remplissage (22) de sorte qu'au moins 50% de la surface du noyau ferromagnétique est en contact direct avec ce matériau de remplissage (22) dont le coefficient de conductivité thermique à 25°C après solidification est supérieur à 0,1 Wm⁻¹K⁻¹ et dont la dureté après solidification à 25°C est de 5 à 70 selon l'échelle de Shore A, le matériau de remplissage (22) étant disposé sur une section longitudinale égale à au moins 50% de la dimension longitudinale du noyau et les dimensions extérieures mesurées perpendiculairement à la dimension longitudinale, **caractérisé en ce que** la plus petite dimension extérieure du matériau de remplissage (22) est supérieure d'au moins 500 µm à la plus grande dimension transversale du noyau ferromagnétique (11, 11.1, 11.2).

2. Sonde magnétométrique orthogonale selon la revendication 1, **alors que** directement la bobine de détection (23, 23.1, 23.2) qui limite spatialement le matériau de remplissage (22), ou la sonde magnétométrique orthogonale comprenant également un deuxième support (21) qui est creux et sur lequel la bobine de détection (23, 23.1, 23.2) est fixée de sorte que le noyau ferromagnétique (11, 11.1, 11.2) se trouve au moins partiellement à l'intérieur de la cavité du deuxième support (21).

3. Sonde magnétométrique orthogonale selon la revendication 1 ou 2, **comprenant également** un support extérieur (25) situé à l'extérieur de la bobine de détection (23, 23.1, 23.2) et une ou plusieurs bobines supplémentaires (24, 24.1, 24.2) qui sont fixées soit sur le support extérieur (25), soit directement sur la bobine de détection (23, 23.1, 23.2).

4. Sonde magnétométrique orthogonale selon l'une quelconque des revendications 1 à 3, le noyau ferromagnétique (11, 11.1, 11.2) **ayant** la forme d'une tige ou d'une bande.

5. Sonde magnétométrique orthogonale selon l'une quelconque des revendications 1 à 3, le noyau ferromagnétique (11, 11.1, 11.2) **ayant** la forme d'un cylindre creux.

6. Sonde magnétométrique orthogonale selon l'une quelconque des revendications 1 à 5 **comprenant** également un premier support (12), le noyau ferromagnétique (11, 11.1, 11.2) étant fixé sur ledit premier support (12).

7. Sonde magnétométrique orthogonale selon la revendication 6, le noyau ferromagnétique (11, 11.1, 11.2) **étant** galvanisé à ses extrémités (14) est fixé au premier support (12) au moyen de soudure tendre (15) de ces extrémités (14) aux contacts (13) formés sur ce premier support (12), et ce premier support (12) est inséré dans la bobine de détection (23, 23.1, 23.2) soit directement soit, lorsque la sonde magnétométrique orthogonale comprend également un deuxième support (21), il est inséré dans le second support (21) qui est situé dans une ou plusieurs bobines de détection (23, 23.1, 23.2).
